# EUROPÄISCHE PATENTSCHRIFT

(11) **EP 4 409 701 B1**
(45) Veröffentlichungstag und Bekanntmachung des Hinweises auf die Patenterteilung: **27.08.2025**
(21) Anmeldenummer: 22786814.8
(22) Anmeldetag: 27.09.2022
(51) Int. Cl.: H01S 5/16, H01S 5/20

(54) **KANTENEMITTIERENDE LASERDIODE MIT ERHÖHTER COD-SCHWELLE**
EDGE-EMITTING LASER DIODE WITH INCREASED COD THRESHOLD
DIODE LASER À ÉMISSION LATÉRALE PRÉSENTANT UN SEUIL DE COD ÉLEVÉ

(30) Priorität: 30.09.2021 DE 102021125392
(43) Veröffentlichungstag der Anmeldung: 07.08.2024
(73) Patentinhaber: Fraunhofer-Gesellschaft zur Förderung der angewandten Forschung e.V., 80686 München (DE)
(72) Erfinder: ADAMS, Martin, 52074 Aachen (DE)
(74) Vertreter: Gagel, Roland
(86) Internationale Anmeldenummer: PCT/EP2022/076789
(87) Internationale Veröffentlichungsnummer: WO 2023/052338

(56) Entgegenhaltungen:
- US-A- 4 845 725
- US-A1- 2002 181 528
- US-A1- 2012 114 000
- US-A1- 2017 062 652
- US-A1- 2020 006 921
- WALKER C L ET AL: "Improved catastrophic optical damage level from laser with nonabsorbing mirrors", IEEE PHOTONICS TECHNOLOGY LETTERS, IEEE, USA, vol. 14, no. 10, 1 October 2002 (2002-10-01), pages 1394 - 1396, XP011432446, ISSN: 1041-1135, DOI: 10.1109/LPT.2002.802080

## Beschreibung

### Technisches Anwendungsgebiet

Die vorliegende Erfindung betrifft eine kantenemittierende Laserdiode, die eine Halbleiter-Heterostruktur aus wenigstens einer aktiven Schicht oder Schichtfolge zwischen zwei wellenleitenden Halbleiterschichten oder -schichtfolgen, die sich zwischen einer Rück- und einer Frontfacette der Laserdiode erstrecken, und eine über der Halbleiter-Heterostruktur angeordnete elektrische Kontaktschicht zur Strominjektion auf einem Substrat aufweist.

Die optische Ausgangsleistung und Lebensdauer von kantenemittierenden Laserdioden werden im Wesentlichen durch thermisches Überrollen und katastrophale optische Degradation (COD) begrenzt. Beim thermischen Überrollen führt ein Ansteigen der mittleren Temperatur des Halbleiterchips der Laserdiode durch die im Betrieb anfallende Verlustleistung zunächst zu einem Abflachen der Leistungskennlinie und schließlich zu einer reversiblen Reduktion der Ausgangsleistung mit zunehmender injizierter Stromstärke. Bei der COD hingegen tritt im Bereich hoher Ausgangsleistungen durch eine lokal begrenzte starke Temperaturerhöhung, in der vorliegenden Patentanmeldung auch als Temperaturüberhöhung bezeichnet, ein irreversibler Abfall der emittierten Leistung durch eine Beschädigung des Halbleitermaterials auf. Diese Temperaturüberhöhung tritt dabei häufig in der Nähe der Frontfacette der Laserdiode auf, aus der die Laserstrahlung austritt.

Die Lebensdauer von Laserdioden wird durch graduelle Degradation, bei der eine langsame Reduktion der optischen Ausgangsleistung als Funktion der Betriebsdauer auftritt, und durch die zuvor angeführte katastrophale optische Degradation limitiert. Die Ursache der graduellen Degradation ist dabei in der Entstehung von Punktdefekten im Halbleiterkristall zu sehen, die u. a. durch höhere Temperaturen und mechanische Verspannungen beschleunigt wird.

### Stand der Technik

Das thermische Überrollen kann durch eine verbesserte Kühlung der Laserdioden bzw. eine Reduktion der anfallenden Wärmeleistung verhindert werden. Hierzu sind unterschiedliche Maßnahmen bekannt, wie bspw. eine doppelseitige oder eine aktive Kühlung, die Verwendung von Wärmesenken mit hoher Wärmeleitfähigkeit, eine Verminderung des Serienwiderstands und der optischen Absorption durch Anpassung des Designs der Halbleiter-Heterostruktur oder auch eine Reduktion des thermischen Widerstands durch Verwendung längerer Halbleiterchips und die Verbreiterung des Injektionsstreifens (Breitstreifenemitter). Damit können gleichzeitig auch die Auswirkungen der graduellen Degradation begrenzt werden, da diese in erster Linie durch die mittlere Temperatur im Halbleiterchip bestimmt wird.

Hinsichtlich der katastrophalen optischen Degradation (COD) sind verschiedene Ansätze zur Erhöhung der Leistungsschwelle für das Auftreten der COD bekannt, die einen starken lokalen Anstieg der Temperatur insbesondere an den Facetten des Halbleiterchips verhindern sollen. Bei einem dieser Ansätze wird die maximale optische Intensität an der Frontfacette durch Verbreiterung des Injektionsstreifens (Breitstreifenemitter) und eine Vergrößerung des Wellenleiters in der vertikalen Richtung (large optical cavity) verringert. Ein anderer Ansatz zur Erhöhung der COD-Schwelle besteht in einer Beschichtung der Facetten der Laserdiode mit geeigneten Schichtsystemen, die die Bindungen an der Bruchkante des Kristalls absättigen und damit zu einer Reduktion der Defektdichte im Halbleiter im Bereich der Facetten führen. Diese Defekte können nichtstrahlende Rekombinationszentren für die injizierten Ladungsträger bilden sowie zur optischen Absorption der austretenden Laserstrahlung führen und damit eine starke Temperaturerhöhung an den Facetten bewirken.

Bei einer weiteren bekannten Technik wird der von der p-Seite der Halbleiter-Heterostruktur injizierte Strom in der Nähe der Facetten blockiert (sog. non-injecting mirror), wie dies z.B. in F. Rinner et al., "Facet temperature reduction by a current blocking layer at the front facets of high-power InGaAs/AlGaAs lasers," Journal of Applied Physics, vol. 93, no. 3, pp. 1848-1850, 2003, beschrieben ist. Durch den lokal unterdrückten Stromfluss wird einerseits die Temperatur an den Facetten in Folge der fehlenden Jouleschen Wärme verringert. Andererseits wird auch die Ladungsträgerdichte an den Facetten reduziert, die als ein entscheidender Treiber des COD angesehen wird. Das lokale Blockieren des injizierten Stroms kann bspw. durch das lokale Aufbringen einer dielektrischen Schicht vor der Metallisierung des p-Kontakts der Laserdiode realisiert werden.

Eine starke lokale Zunahme der Temperatur kann auch durch die resultierende Verschiebung des optischen Verstärkungsspektrums der aktiven Zone der Halbleiter-Heterostruktur zu höheren Wellenlängen eine Absorption des im Wellenleiter propagierenden Laserlichts bewirken. Das Einsetzen dieser Absorption wird häufig als Ausgangspunkt des COD gesehen. Eine Vergrößerung der Bandlücke des Quantenfilms als aktiver Schicht der Laserdiode in der Nähe der Facetten (sog. non-absorbing mirror) sorgt dafür, dass diese Absorption erst bei höheren Temperaturen auftritt und erhöht damit die COD-Schwelle. Das Verfahren kann bspw. durch Quantum-Well-Intermixing umgesetzt werden, wie dies bspw. in S. D. McDougall et al., "Monolithic integration via a universal damage enhanced quantum-well intermixing technique," IEEE J. Select. Topics Quantum Electron., vol. 4, no. 4, pp. 636-646, 1998, oder in C. L. Walker et al., "Improved catastrophic optical damage level from laser with nonabsorbing mirrors," IEEE Photon. Technol. Lett., vol. 14, no. 10, pp. 1394-1396, 2002, beschrieben ist.

Es wird weiterhin auf die folgenden Dokumente verwiesen:
- US 2002/181528 A1 (HIROYAMA) 5. Dezember 2002 ;
- US 2020/006921 A1 (IKEDO) 2. Januar 2020 ;
- US 2012/114000 A1 (TANIGUCHI) 10. Mai 2012 ;
- US 4 845 725 A (WELCH) 4. Juli 1989 ;
- US 2017/062652 A1 (IMAI) 2. März 2017.

Die Aufgabe der vorliegenden Erfindung besteht darin, ein Design für eine kantenemittierende Laserdiode anzugeben, durch das die Leistungsschwelle für das Auftreten der katastrophalen optischen Degradation und somit auch die erzielbare optische Ausgangsleistung und die Lebensdauer der Laserdiode erhöht werden.

### Darstellung der Erfindung

Die Aufgabe wird mit der kantenemittierenden Laserdiode gemäß Patentanspruch 1 gelöst. Vorteilhafte Ausgestaltungen dieser Laserdiode sind Gegenstand der abhängigen Patentansprüche oder lassen sich der nachfolgenden Beschreibung sowie den Ausführungsbeispielen entnehmen.

Die vorgeschlagene kantenemittierende Laserdiode weist in bekannter Weise eine Halbleiter-Heterostruktur aus wenigstens einer aktiven Schicht oder Schichtfolge (z.B. aus Mehrfachquantenfilmen) zwischen zwei wellenleitenden Halbleiterschichten oder -schichtfolgen, die sich zwischen einer Rück- und einer Frontfacette der Laserdiode erstrecken, und eine über der Halbleiter-Heterostruktur angeordnete elektrische Kontaktschicht zur Strominjektion auf einem Substrat, insbesondere einem Halbleitersubstrat auf. Die durch die Laserdiode erzeugte Laserstrahlung tritt dabei durch die Frontfacette aus. Die beiden wellenleitenden Halbleiterschichten oder -schichtfolgen sind in direktem Kontakt zur aktiven Schicht oder Schichtfolge oder grenzen über eine oder mehrere Übergangsschichten an die aktive Schicht oder Schichtfolge an. Unterhalb und oberhalb der wellenleitenden Halbleiterschichten oder -schichtfolgen schließen sich in der Regel noch die Cladding-Schichten an. Es können sich auch noch weitere Halbleiter- oder andere Schichten anschließen. Zwischen den unterschiedlichen Schichten oder Schichtfolgen können zusätzlich auch noch Übergangsschichten ausgebildet sein. Die vorgeschlagene Laserdiode zeichnet sich dadurch aus, dass die zwei wellenleitenden Halbleiterschichten oder -schichtfolgen zwischen der Rück- und der Frontfacette jeweils einen oder mehrere lokal begrenzte modifizierte Abschnitte aufweisen, durch die vertikale Leckströme aus der aktiven Schicht oder Schichtfolge, die beim Betrieb der Laserdiode auftreten, verringert oder unterdrückt werden. Die Verringerung oder Unterdrückung der vertikalen Leckströme erfolgt durch eine gegenüber dem oder den zwischen der Rück- und der Frontfacette verbleibenden Abschnitten veränderte Ausbildung der wellenleitenden Halbleiterschichten oder -schichtfolgen in dem jeweiligen modifizierten Abschnitt. Der oder die modifizierten Abschnitte sind dabei an Positionen angeordnet, an denen ohne diese Verringerung oder Unterdrückung der vertikalen Leckströme unerwünschte Temperaturüberhöhungen beim Betrieb der Laserdiode auftreten würden, also starke lokale Temperaturanstiege, die zu einer COD führen würden. Unter vertikalen Leckströmen sind dabei Leckströme zu verstehen, die sich im Wesentlichen senkrecht zur aktiven Schicht oder Schichtfolge aus der aktiven Schicht oder Schichtfolge in benachbarte Schichten der Halbleiter-Heterostruktur ausbreiten. Unter lokal begrenzten Abschnitten sind Abschnitte zu verstehen, die sich nicht über die gesamte oder einen überwiegenden Teil der Länge der Wellenleiter zwischen Front- und Rückfacette erstrecken, sondern nur über jeweils einen kleinen Teil davon, der vorzugsweise jeweils < 3% dieser Länge beträgt.

Vertikale Leckströme können im Verlauf des COD neben der oben beschriebenen einsetzenden Absorption auftreten. Die Absorption durch Verschiebung des Verstärkungsspektrums führt zu einer starken lokalen Zunahme der Ladungsträgerdichte innerhalb der aktiven Schicht oder Schichtfolge bzw. Zone. Wird dabei ein kritischer Wert überschritten, diffundieren diese Ladungsträger trotz der vorliegenden Energiebarriere in die umgebenden Halbleiterschichten und rekombinieren dort nichtstrahlend. Die dadurch zunehmende lokale Wärmequelle bewirkt einen weiteren Temperaturanstieg, wodurch sich der Effekt kontinuierlich verstärkt, bis schließlich eine Zerstörung der Laserdiode resultiert, wenn die Schmelztemperatur des Halbleitermaterials erreicht wird. Bei der vorliegenden Erfindung wurde erkannt, dass durch eine lokale Reduzierung oder Unterdrückung dieser vertikalen Leckströme an der oder den kritischen Stellen durch geeignete lokale Modifikation der an die aktive Schicht oder Schichtfolge direkt oder über eine oder mehrere Übergangsschichten angrenzenden wellenleitenden Halbleiterschichten oder -schichtfolgen die Leistungsschwelle für das Auftreten der COD erhöht werden kann. Simulationsrechnungen zeigen, dass erst das Einsetzen der vertikalen Leckströme eine positive Rückkopplungsschleife startet, die immer stärker werdende Wärmequellen erzeugt und damit schließlich zum lokalen Aufschmelzen des Halbleitermaterials sowie zu einer irreversiblen Beschädigung der Laserdiode führt. Die lokale Modifikation der wellenleitenden Halbleiterschichten oder -schichtfolgen zur lokalen Reduzierung oder Unterdrückung dieser vertikalen Leckströme führt somit zu einer höheren erzielbaren optischen Ausgangsleistung und einer höheren Lebensdauer der Laserdiode.

Die lokale Modifikation wird dabei in der Regel in einem lokal begrenzten Abschnitt im Bereich der Frontfacette oder jeweils in einem lokal begrenzten Abschnitt im Bereich der Frontfacette und im Bereich der Rückfacette durchgeführt, da diese Bereiche als häufiger Ausgangspunkt der COD in kantenemittierenden Laserdioden identifiziert werden. Je nach Laserdiodentyp kann eine Temperaturüberhöhung jedoch auch an anderen longitudinalen Abschnitten zwischen Front- und Rückfacette auftreten, so dass dann an diesen Abschnitten eine entsprechende lokale Modifikation der wellenleitenden Halbleiterschichten oder -schichtfolgen erfolgt.

Die Reduzierung oder Unterdrückung der vertikalen Leckströme kann durch unterschiedliche lokale Modifikation der wellenleitenden Halbleiterschichten oder -schichtfolgen, also eine gegenüber den verbleibenden Abschnitten veränderte Ausbildung dieser Halbleiterschichten oder -schichtfolgen, erreicht werden. In einer Ausgestaltung der vorgeschlagenen Laserdiode ist hierzu die Bandlücke der wellenleitenden Halbleiterschichten oder -schichtfolgen in dem jeweils modifizierten Abschnitt gegenüber dem oder den verbleibenden Abschnitten vergrößert. Dadurch wird die Energiebarriere zwischen der aktiven Schicht oder Schichtfolge und den umgebenden Halbleiterschichten erhöht und die Diffusion der Ladungsträger unterdrückt. Dies führt dann zu einer Verringerung oder Unterdrückung der vertikalen Leckströme in diesen Bereichen.

In einer weiteren Ausgestaltung der vorgeschlagenen kantenemittierenden Laserdiode sind die beiden wellenleitenden Halbleiterschichten oder - schichtfolgen in dem einen oder den mehreren modifizierten Abschnitten so ausgebildet, dass die Beweglichkeit der Ladungsträger gegenüber dem oder den verbleibenden Abschnitten reduziert ist. Durch diese Reduzierung der Ladungsträgerbeweglichkeit in den wellenleitenden Halbleiterschichten oder -schichtfolgen wird der Diffusionskoeffizient lokal reduziert und damit der Diffusionsstrom unterdrückt. Auch dies führt zu einer Reduzierung oder Unterdrückung der vertikalen Leckströme und somit zur Erhöhung der COD-Schwelle.

Bei der vorgeschlagenen kantenemittierenden Laserdiode sind vorzugsweise nur die wellenleitenden Halbleiterschichten oder -schichtfolgen nicht jedoch die aktive Schicht oder Schichtfolge lokal modifiziert. In anderen Ausführungsformen kann auch eine Kombination der beiden obigen Ausgestaltungen oder einer oder beider Ausgestaltungen mit einer oder mehreren der in der Beschreibungseinleitung zur Erhöhung der COD-Schwelle erläuterten Maßnahmen bei der vorgeschlagenen kantenemittierenden Laserdiode erfolgen. Durch eine derartige Kombination wird die COD-Schwelle und damit auch die durch die COD begrenzte Lebensdauer der Laserdiode weiter erhöht.

Die vorliegende Erfindung lässt sich mit allen Typen kantenemittierender Laserdioden umsetzen. Besonders vorteilhaft lassen sich damit jedoch kantenemittierende Laserdioden realisieren, die hohe optische Ausgangsleistungen liefern sollen, bspw. im Bereich der Lasermaterialbearbeitung als direkte Diodenlasersysteme oder als Pumpmodule für Faser- und Scheibenlaser. Weiterhin ist die Umsetzung der Erfindung für Lasersysteme vorteilhaft, die eine hohe Zuverlässigkeit erfordern, wie z. B. in der transatlantischen optischen Telekommunikation oder beim Einsatz im Weltraum.

### Kurze Beschreibung der Zeichnungen

Die vorgeschlagene kantenemittierende Laserdiode wird nachfolgend anhand von Ausführungsbeispielen in Verbindung mit den Zeichnungen nochmals näher erläutert. Hierbei zeigen:
- Fig. 1: ein Beispiel für eine typische Heterostruktur einer kantenemittierenden Laserdiode gemäß dem Stand der Technik in der vertikal-longitudinalen Ebene;
- Fig. 2: ein Beispiel für die Ausbildung der Heterostruktur einer Laserdiode gemäß Figur 1 unter Einsatz eines non-injecting mirror gemäß dem Stand der Technik;
- Fig. 3: ein Beispiel für die Ausgestaltung der Heterostruktur einer Laserdiode gemäß Figur 1 unter Einsatz eines non-absorbing mirror gemäß dem Stand der Technik;
- Fig. 4: ein Ausführungsbeispiel für die Ausbildung der Heterostruktur zur lokalen Unterdrückung von vertikalen Leckströmen aus der aktiven Schicht gemäß der vorliegenden Erfindung;
- Fig. 5: ein Beispiel für den Verlauf der Bandlücke entlang der in Figur 4 angedeuteten Schnitte A und B bei lokaler Vergrößerung der Bandlücke in den an die aktive Schicht angrenzenden Schichten;
- Fig. 6: ein Beispiel für den Verlauf der Beweglichkeit der Ladungsträger entlang der in Figur 4 angedeuteten Schnitte A und B bei einer lokalen Verringerung der Beweglichkeit in den an die aktive Schicht angrenzenden Schichten; und
- Fig. 7: ein Ausführungsbeispiel für die Ausbildung der Heterostruktur gemäß der vorliegenden Erfindung in Kombination mit Maßnahmen des Standes der Technik.

### Wege zur Ausführung der Erfindung

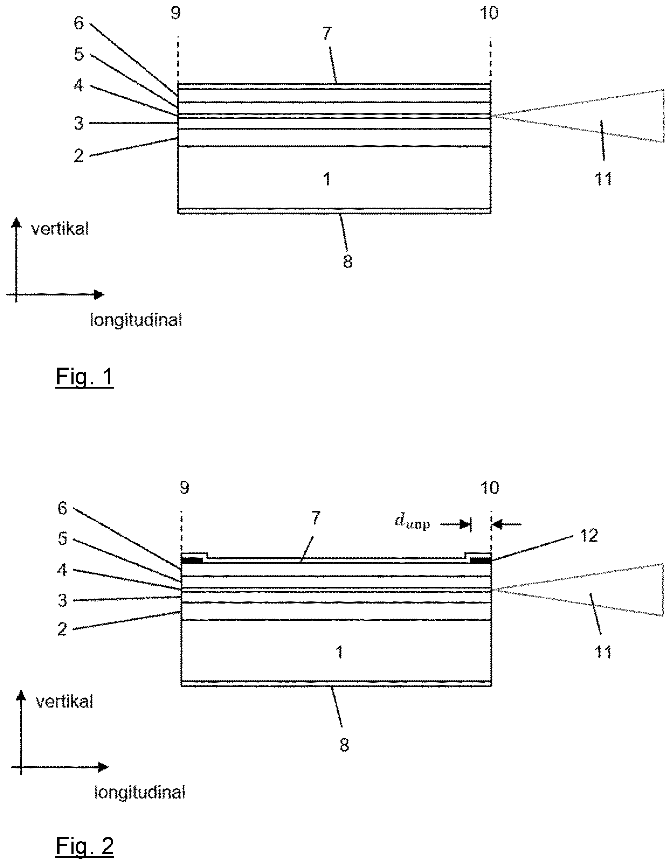

Die vorgeschlagene kantenemittierende Laserdiode weist in bekannter Weise eine Halbleiter-Heterostruktur mit wenigstens einer aktiven Schicht zwischen zwei wellenleitenden Halbleiterschichten auf einem Substrat auf. Figur 1 zeigt eine vereinfachte, schematische Darstellung eines Beispiels für die typische Heterostruktur einer kantenemittierenden Laserdiode in der vertikal-longitudinalen Ebene. Die Heterostruktur weist in diesem Beispiel auf einem n-Substrat 1 eine Schichtfolge aus einem n-Cladding 2, einem n-Wellenleiter 3, der Aktivschicht 4, einem p-Wellenleiter 5 und einem p-Cladding 6 auf. Auf dieser Schichtfolge aus Halbleiterschichten ist ein p-Kontakt 7 zur Strominjektion aufgebracht. Die Rückseite des n-Substrats 1 ist mit einem n-Kontakt 8 versehen. Die Rückfacette 9 und die Frontfacette 10 dieser Laserdiode sind in der Figur ebenfalls gekennzeichnet. Der von der Laserdiode erzeugte Laserstrahl 11 tritt durch die Frontfacette 10 aus.

Zur Vermeidung lokaler Temperaturüberhöhungen, die häufig an der Frontfacette 10 und der Rückfacette 9 einer derartigen kantenemittierenden Laserdiode auftreten, sind die in der Beschreibungseinleitung genannten Maßnahmen bekannt. Figur 2 zeigt hierzu ein Beispiel für eine dieser Maßnahmen, den sog. non-injecting mirror zur Unterdrückung des am p-Kontakt 7 injizierten Stroms in einem Bereich dᵤₙₚ an den Facetten 9, 10. In diesem Bereich wird bei der Herstellung der Laserdiode lokal eine dielektrische Schicht als Isolator 12 vor der Metallisierung durch den p-Kontakt 7 aufgebracht, wie dies in der Figur 2 angedeutet ist. Durch diesen Isolator 12 wird lokal der Stromfluss vom p-Kontakt 7 in die Heterostruktur unterdrückt und damit die Temperatur an den Facetten 9, 10 in Folge der fehlenden Jouleschen Wärme verringert.

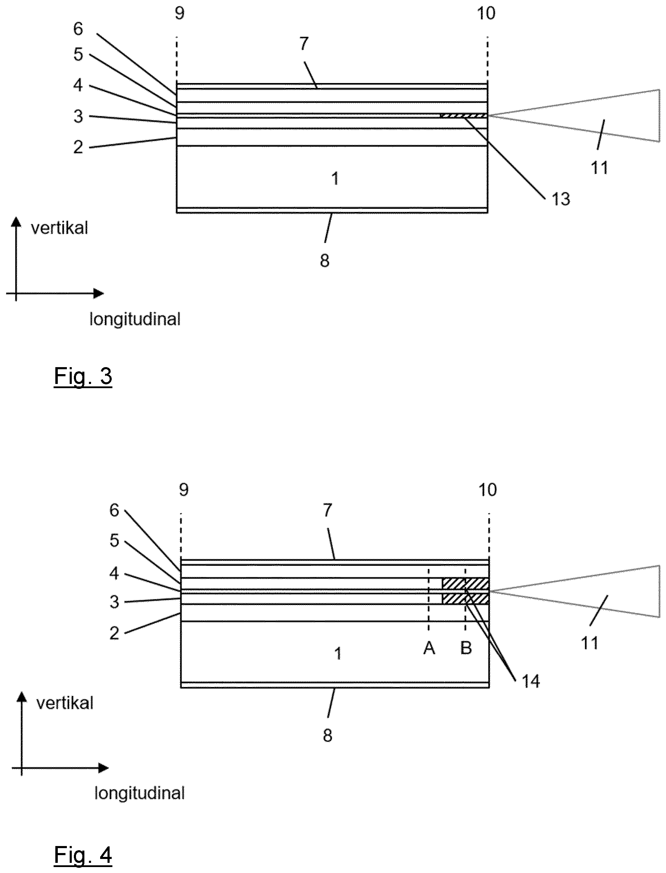

Figur 3 zeigt ein weiteres Beispiel einer bekannten Maßnahme zur Erhöhung der COD-Schwelle, dem sog. non-absorbing mirror, wie sie in der Beschreibungseinleitung kurz erläutert wurde. Hierzu wird die aktive Schicht 4 im vorliegenden Beispiel im Bereich der Frontfacette 10 so modifiziert, dass sie eine erhöhte Bandlücke aufweist. Der entsprechende lokal modifizierte Abschnitt 13 mit erhöhter Bandlücke ist in der Figur 3 angedeutet. Diese Erhöhung der Bandlücke sorgt dafür, dass eine Absorption der im Wellenleiter propagierenden Laserstrahlung durch Verschiebung des optischen Verstärkungsspektrums der aktiven Zone aufgrund einer Temperaturerhöhung erst bei höheren Temperaturen auftritt und damit die COD-Schwelle erhöht wird.

Figur 4 zeigt schließlich ein Ausführungsbeispiel der vorgeschlagenen kantenemittierenden Laserdiode, ebenfalls in vereinfachter, schematischer Darstellung. Bei dieser Laserdiode sind der n-Wellenleiter 3 und der p-Wellenleiter 5 in den an die Frontfacette 10 angrenzenden Abschnitten 14 lokal so modifiziert, dass in diesen Abschnitten 14 der an die Aktivschicht 4 angrenzenden Halbleiterschichten 3, 5 eine erhöhte Bandlücke vorliegt und/oder eine verringerte Mobilität der Ladungsträger auftritt und damit die vertikalen Leckströme aus der Aktivschicht 4 in diesem Bereich verringert oder unterdrückt werden. Im Beispiel der Figur 4 ist diese lokale Modifikation nur an der Frontfacette 10 dargestellt. Je nach Auftreten der Temperaturüberhöhungen kann diese Modifikation alternativ oder zusätzlich auch an der Rückfacette 9 oder an anderen longitudinalen Positionen zwischen Rückfacette 9 und Frontfacette 10 der Heterostruktur erfolgen. Die Ausdehnung dieser lokal begrenzten modifizierten Abschnitte kann bspw. im Bereich von 30 µm bis 100 µm liegen.

Eine lokale Erhöhung der Bandlücke kann in den entsprechenden Abschnitten bspw. mit folgenden Verfahren bei der Herstellung der Laserdiode realisiert werden. Eine Möglichkeit besteht darin, die Heterostruktur bei der Herstellung lokal in den zu modifizierenden Abschnitten zurückzuätzen und ein erneutes epitaktisches Wachstum (epitaxial regrowth) der Wellenleiterstruktur mit vergrößerter Bandlücke in den zur Aktivschicht 4 benachbarten Schichten 3, 5 durchzuführen. Eine weitere Möglichkeit besteht in der Implantation geeigneter Ionen in diesen Abschnitten in den an die Aktivschicht 4 angrenzenden Wellenleiterschichten 3, 5 mit anschließender Hochtemperaturbehandlung zur Ausheilung der entstandenen Defekte, wie dies bspw. in P. G. Piva et al., "Reduction of InGaAs/GaAs laser facet temperatures by band gap shifted extended cavities," Appl. Phys. Lett., vol. 70, no. 13, pp. 1662-1664, 1997, beschrieben ist. Eine dritte Möglichkeit besteht in einem lokalen Aufdampfen einer dielektrischen Schicht auf die jeweils gewachsene Halbleiterschicht und eine anschließende Hochtemperaturbehandlung zur Eindiffusion der an der Grenzfläche der dielektrischen Schicht entstandenen Defekte in die Halbleiterschicht, wie dies bspw. auch in der weiter vorne genannten Veröffentlichung von S. D. McDougall et al. in Verbindung mit der Aktivschicht beschrieben ist. Dies ist selbstverständlich keine abschließende Aufzählung. Die Eindiffusion oder Implantation von Störstellen stellt dabei nicht den eigentlichen Prozess zur Vergrößerung der Bandlücke dar. Die Störstellen erleichtern lediglich die atomare Interdiffusion (Intermixing) zwischen verschiedenen benachbarten Halbleiterschichten. Für eine Vergrößerung der Bandlücke in den wellenleitenden Halbleiterschichten darf die Eindiffusion oder Implantation der Störstellen daher nur in den wellenleitenden Schichten und den Cladding-Schichten, nicht jedoch in der aktiven Schicht erfolgen, um ein Intermixing nicht zwischen der aktiven Schicht und dem Wellenleiter, sondern zwischen dem Wellenleiter und der Cladding-Schicht umzusetzen, in der die Bandlücke größer ist als im Wellenleiter.

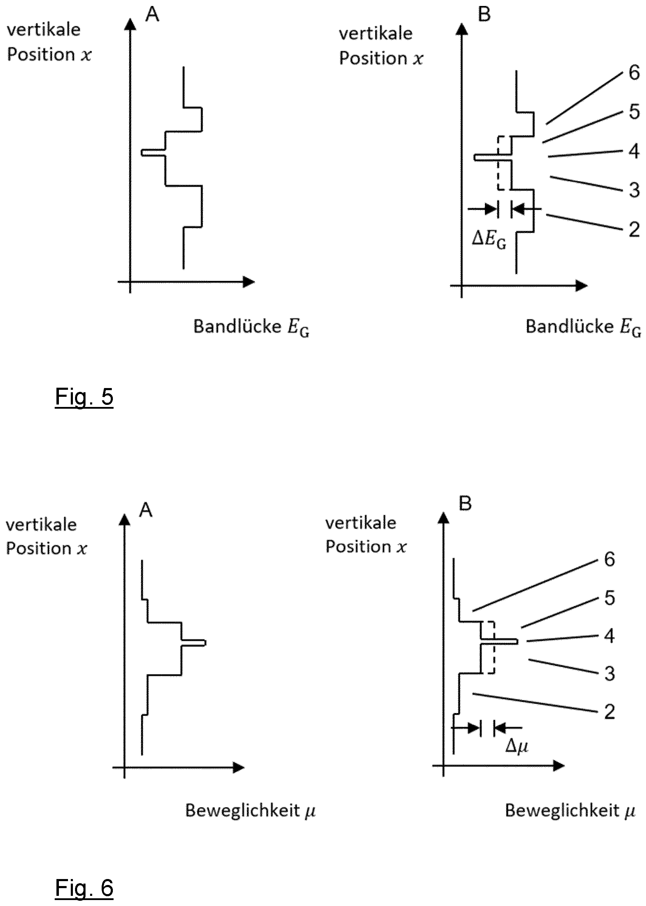

Figur 5 zeigt ein Beispiel für den Verlauf der Bandlücke bei derart modifizierten Abschnitten 14 entlang der beiden in Figur 4 eingezeichneten Schnitte A und B. Aus dieser Darstellung ist die Erhöhung der Bandlücke ausschließlich in den entsprechend modifizierten Abschnitten des n-Wellenleiters 3 und des p-Wellenleiters 5 erkennbar, die zu einer Reduktion oder Unterdrückung der vertikalen Leckströme führt. So kann bspw. bei einer Änderung der Bandlücke im Bereich von 120 bis 180 meV in den der Aktivschicht 4 benachbarten Halbleiterschichten 3, 5 eine deutliche Erhöhung der COD-Schwelle von etwa 30% erreicht werden, wie durch Simulationsrechnungen ermittelt wurde. Zur Erhöhung der Bandlücke können hierzu bspw. die Ionen von Bor, Silizium oder Zink genutzt werden. Dies gilt auch für die nachfolgend beschriebene Verringerung der Mobilität der Ladungsträger durch Ionenimplantation.

Bei einer Verringerung der Mobilität der Ladungsträger in den in Figur 4 dargestellten modifizierten Abschnitten 14 kann sich ein Verlauf der Beweglichkeit der Ladungsträger ergeben, wie er in Figur 6 entlang der beiden in Figur 4 eingezeichneten Schnitte A und B dargestellt ist. Aus dieser Darstellung ist ersichtlich, dass die Beweglichkeit in den modifizierten Abschnitten 14 der an die Aktivschicht angrenzenden Schichten (p-Wellenleiter 5 und n-Wellenleiter 3) um einen Wert Δµ erniedrigt ist. Diese Verringerung der Beweglichkeit kann durch unterschiedliche Maßnahmen bei der Herstellung der Laserdiode erreicht werden. Eine dieser Maßnahmen besteht in der lokalen Implantation geeigneter Ionen in den zu modifizierenden Abschnitten der an die Aktivschicht 4 angrenzenden Halbleiterschichten 3, 5. Die Dotierstoffe müssen dabei so gewählt werden, dass sie nur Gitterfehler erzeugen - und damit die Beweglichkeit der Ladungsträger reduzieren - nicht jedoch die Stromleitfähigkeit erhöhen wie im Falle elektrisch aktiver Dotierstoffe. Bei der Implantation der Ionen muss der üblicherweise bei einer Dotierung folgende Hochtemperaturschritt zum Ausheilen der entstandenen Defekte ausbleiben, um entsprechend die Beweglichkeit der Ladungsträger zu verringern. Eine weitere Möglichkeit besteht in einer Oxidation dieser Halbleiterschichten 3, 5, nicht jedoch der aktiven Schicht, in der Nähe der jeweiligen Facette. Diese Oxidation erfolgt dann vor einer Facettenbeschichtung von der Seite der Facette her in die jeweiligen Schichten. Eine weitere mögliche Maßnahme zur lokalen Verringerung der Ladungsträgerbeweglichkeit besteht in einer lokalen Modifikation oder Störung der Kristallstruktur des entsprechenden Abschnittes mit einem Hochleistungs-Ultrakurzpulslaser. Die Wellenlänge des eingesetzten Lasers muss dabei so gewählt sein, dass die Halbleiterschicht für die Laserstrahlung ausreichend transparent ist. Diese Aufzählung der Möglichkeiten ist selbstverständlich wiederum nicht abschließend.

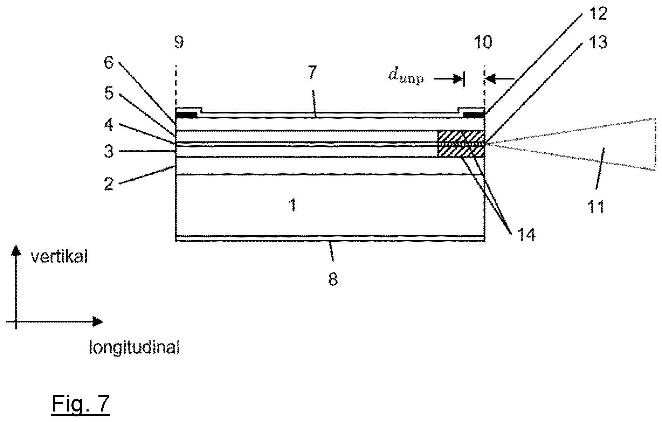

Bei der vorgeschlagenen kantenemittierenden Laserdiode lassen sich zusätzlich auch die bereits bekannten Techniken zur Erhöhung der COD-Schwelle einsetzen. Figur 7 zeigt ein entsprechendes Beispiel, bei dem die erfindungsgemäß vorgeschlagenen Maßnahmen mit den Techniken aus den Figuren 2 und 3 kombiniert wurden. Die Laserdiode dieses Beispiels weist somit neben den lokal modifizierten Abschnitten 14 in den an die Aktivschicht 4 angrenzenden Halbleiterschichten 3, 5 auch eine erhöhte Bandlücke in einem Bereich 13 der Aktivschicht 4 in der Nähe der Frontfacette 10 auf sowie isolierende Bereiche 12 unterhalb des p-Kontakts 7 an der Front- 10 und an der Rückfacette 9, wie dies in Figur 7 erkennbar ist.

### Bezugszeichenliste

- 1: n-Substrat
- 2: n-Cladding
- 3: n-Wellenleiter
- 4: Aktivschicht
- 5: p-Wellenleiter
- 6: p-Cladding
- 7: p-Kontakt
- 8: n-Kontakt
- 9: Rückfacette
- 10: Frontfacette
- 11: Laserstrahl
- 12: Isolator
- 13: lokal modifizierter Bereich der Aktivschicht
- 14: lokal modifizierter Abschnitt der Wellenleiter

## Patentansprüche

1. Kantenemittierende Laserdiode, die eine Halbleiter-Heterostruktur aus wenigstens einer aktiven Schicht oder Schichtfolge (4) zwischen zwei wellenleitenden Halbleiterschichten oder -schichtfolgen (3, 5), die sich zwischen einer Rück- (9) und einer Frontfacette (10) der Laserdiode erstrecken, und eine über der Halbleiter-Heterostruktur angeordnete elektrische Kontaktschicht (7) zur Strominjektion auf einem Substrat (1) aufweist,
wobei die beiden wellenleitenden Halbleiterschichten oder -schichtfolgen (3, 5) jeweils einen oder mehrere lokal begrenzte modifizierte Abschnitte (14) zwischen der Rück- (9) und der Frontfacette (10) aufweisen, in dem oder denen vertikale Leckströme aus der aktiven Schicht oder Schichtfolge (4) beim Betrieb der Laserdiode durch eine gegenüber einem oder mehreren zwischen der Rück- (9) und der Frontfacette (10) verbleibenden Abschnitten veränderte Ausbildung der jeweiligen wellenleitenden Halbleiterschicht oder -schichtfolge (3, 5) verringert oder unterdrückt werden, wobei der oder die modifizierten Abschnitte (14) an Positionen angeordnet sind, an denen ohne diese Verringerung oder Unterdrückung der vertikalen Leckströme unerwünschte Temperaturüberhöhungen beim Betrieb der Laserdiode auftreten würden.

2. Kantenemittierende Laserdiode nach Anspruch 1,
**dadurch gekennzeichnet,**
**dass** die beiden wellenleitenden Halbleiterschichten oder -schichtfolgen (3, 5) in den modifizierten Abschnitten (14) so ausgebildet sind, dass eine Bandlücke dieser wellenleitenden Halbleiterschichten oder -schichtfolgen in den modifizierten Abschnitten (14) gegenüber dem oder den verbleibenden Abschnitten vergrößert ist.

3. Kantenemittierende Laserdiode nach Anspruch 1 oder 2, **dadurch gekennzeichnet,**
**dass** die beiden wellenleitenden Halbleiterschichten oder -schichtfolgen (3, 5) in den modifizierten Abschnitten (14) so ausgebildet sind, dass eine Beweglichkeit der Ladungsträger in den modifizierten Abschnitten (14) gegenüber dem oder den verbleibenden Abschnitten verringert ist.

4. Kantenemittierende Laserdiode nach Anspruch 3,
**dadurch gekennzeichnet,**
**dass** die beiden wellenleitenden Halbleiterschichten oder -schichtfolgen (3, 5) in den modifizierten Abschnitten (14) oxidiert sind.

5. Kantenemittierende Laserdiode nach einem der Ansprüche 1 bis 4,
**dadurch gekennzeichnet,**
**dass** die beiden wellenleitenden Halbleiterschichten oder -schichtfolgen (3, 5) in den modifizierten Abschnitten (14) dotiert und in dem oder den verbleibenden Abschnitten nicht dotiert sind oder eine gegenüber dem oder den verbleibenden Abschnitten veränderte Zusammensetzung oder Konzentration an Dotierstoffen aufweisen.

6. Kantenemittierende Laserdiode nach einem der Ansprüche 1 bis 5,
**dadurch gekennzeichnet,**
**dass** die Halbleiter-Heterostruktur ausgehend vom Substrat (1) wenigstens eine n-dotierte Cladding-Schicht oder -Schichtfolge (2), die erste wellenleitende Halbleiterschicht oder - schichtfolge (3), die aktive Schicht oder Schichtfolge (4), die zweite wellenleitende Halbleiterschicht oder -schichtfolge (5) und eine p-dotierte Cladding-Schicht oder -Schichtfolge (6) aufweist.

7. Kantenemittierende Laserdiode nach einem der Ansprüche 1 bis 6,
**dadurch gekennzeichnet,**
**dass** der oder die modifizierten Abschnitte (14) an oder in der Nähe der Frontfacette (10) und/oder der Rückfacette (9) angeordnet sind.

## Claims

1. Edge-emitting laser diode which has a semiconductor heterostructure consisting of at least one active layer or layer sequence (4) between two wave-guiding semiconductor layers or layer sequences (3, 5), which extend between a rear (9) and a front facet (10) of the laser diode, and an electrical contact layer (7) for injecting current arranged over the semiconductor heterostructure on a substrate (1),
wherein the two wave-guiding semiconductor layers or layer sequences (3, 5) each have one or more locally delimited modified portions (14) between the rear facet (9) and the front facet (10), in which vertical leakage currents from the active layer or layer sequence (4) during operation of the laser diode are reduced or suppressed by a design of the respective wave-guiding semiconductor layer or layer sequence (3, 5) that is modified in comparison with one or more remaining portions between the rear facet (9) and the front facet (10), wherein the one or more modified portions (14) are arranged in positions in which undesired excessive temperature increases would occur if the laser diode were operated without said reduction or suppression of the vertical leakage currents.

2. Edge-emitting laser diode according to Claim 1,
**characterized in that**
the two wave-guiding semiconductor layers or layer sequences (3, 5) are designed in the modified portions (14) in such manner that a band gap of these wave-guiding semiconductor layers or layer sequences is enlarged in the modified portions (14) compared with the one or more remaining portions.

3. Edge-emitting laser diode according to Claim 1 or 2,
**characterized in that**
the two wave-guiding semiconductor layers or layer sequences (3, 5) are designed in the modified portions (14) in such manner that a mobility of the charge carriers in the modified portions (14) is reduced compared with the one or more remaining portions.

4. Edge-emitting laser diode according to Claim 3,
**characterized in that**
the two wave-guiding semiconductor layers or layer sequences (3, 5) are oxidised in the modified portions (14) .

5. Edge-emitting laser diode according to any one of Claims 1 to 4,
**characterized in that**
the two wave-guiding semiconductor layers or layer sequences (3, 5) are doped in the modified portions (14) and not doped in the one or more remaining portions, or they have a composition or concentration of dopants that has been modified compared with the one or more remaining portions.

6. Edge-emitting laser diode according to any one of Claims 1 to 5,
**characterized in that**
starting from the substrate the semiconductor heterostructure includes at least one n-doped cladding layer or layer sequence (2), the first wave-guiding semiconductor layer or layer sequence (3), the active layer or layer sequence (4), the second wave-guiding semiconductor layer or layer sequence (5), and a p-doped cladding layer or layer sequence (6).

7. Edge-emitting laser diode according to any one of Claims 1 to 6,
**characterized in that**
the one or more modified portions (14) are arranged on or in the vicinity of the front facet (10) and/or the rear facet (9).

## Revendications

1. Diode laser à émission latérale, qui présente une hétérostructure semi-conductrice constituée d'au moins une couche ou une séquence de couches active (4) entre deux couches ou séquences de couches semi-conductrices de guidage d'ondes (3, 5) qui s'étendent entre une facette arrière (9) et une facette avant (10) de la diode laser et présente une couche de contact électrique (7) disposée au-dessus de l'hétérostructure semi-conductrice pour l'injection de courant sur un substrat (1),
dans laquelle les deux couches ou séquences de couches semi-conductrices de guidage d'ondes (3, 5) présentent chacune une ou plusieurs sections modifiées (14) localement limitées entre la facette arrière (9) et la facette avant (10), dans laquelle ou lesquelles les courants de fuite verticaux de la couche ou séquence de couches active (4) pendant le fonctionnement de la diode laser sont réduits ou supprimés par une configuration modifiée de la couche ou séquence de couches semi-conductrices de guidage d'ondes respective (3, 5) par rapport à une ou plusieurs sections restantes entre la facette arrière (9) et la facette avant (10), dans laquelle la ou les sections modifiées (14) sont disposées à des positions auxquelles, sans cette réduction ou suppression des courants de fuite verticaux, des augmentations de température indésirables se produiraient pendant le fonctionnement de la diode laser.

2. Diode laser à émission latérale selon la revendication 1, **caractérisée en ce que** les deux couches ou séquences de couches semi-conductrices de guidage d'ondes (3, 5) dans les sections modifiées (14) sont formées de telle sorte que une bande interdite de ces couches ou séquences de couches semi-conductrices de guidage d'ondes dans les sections modifiées (14) soit augmentée par rapport à la ou aux sections restantes.

3. Diode laser à émission latérale selon la revendication 1 ou 2, **caractérisée en ce que** les deux couches ou séquences de couches semi-conductrices de guidage d'ondes (3, 5) dans les sections modifiées (14) sont formées de telle sorte qu'une mobilité des porteurs de charge dans les sections modifiées (14) soit réduite par rapport aux sections restantes.

4. Diode laser à émission latérale selon la revendication 3, **caractérisée en ce que** les deux couches ou séquences de couches semi-conductrices de guidage d'ondes (3, 5) dans les sections modifiées (14) sont oxydées.

5. Diode laser à émission latérale selon une des revendications 1 à 4, **caractérisée en ce que** les deux couches ou séquences de couches semi-conductrices de guidage d'ondes (3, 5) sont dopées dans les sections modifiées (14) et non dopées dans les sections restantes ou présentent une composition ou une concentration en dopants différente de celle des sections restantes.

6. Diode laser à émission latérale selon une des revendications 1 à 5, **caractérisée en ce que** l'hétérostructure semi-conductrice, à partir du substrat (1), présente au moins une couche ou séquence de couches de revêtement dopée n (2), la première couche ou séquence de couches semi-conductrices de guidage d'ondes (3), la couche ou séquence de couches active (4), la deuxième couche ou séquence de couches semi-conductrices de guidage d'ondes (5) et une couche ou séquence de couches de revêtement dopée p (6).

7. Diode laser à émission latérale selon une des revendications 1 à 6, **caractérisée en ce que** la ou les sections modifiées (14) sont disposées sur ou à proximité de la facette avant (10) et/ou de la facette arrière (9).
